# EUROPÄISCHE PATENTSCHRIFT

(11) **EP 2 443 669 B1**
(45) Veröffentlichungstag und Bekanntmachung des Hinweises auf die Patenterteilung: **23.05.2018**
(21) Anmeldenummer: 10747802.6
(22) Anmeldetag: 31.05.2010
(51) Int. Cl.: H01L 31/18, H01L 31/0216

(54) **HALBLEITERVORRICHTUNG UND HERSTELLUNGSVERFAHREN EINER HALBLEITERVORRICHTUNG**
SEMICONDUCTOR APPARATUS AND METHOD OF FABRICATION FOR A SEMICONDUCTOR APPARATUS
DISPOSITIF SEMI-CONDUCTEUR ET PROCÉDÉ DE FABRICATION DE DISPOSITIF SEMI-CONDUCTEUR

(30) Priorität: 16.06.2009 DE 102009025977
(43) Veröffentlichungstag der Anmeldung: 25.04.2012
(73) Patentinhaber: Hanwha Q CELLS GmbH, 06766 Bitterfeld-Wolfen (DE)
(72) Erfinder: ENGELHART, Peter, 04157 Leipzig (DE); SEGUIN, Robert, 12109 Berlin (DE); KESSELS, Wilhelmus, Mathijs, Marie, NL-5045ZZ Tilburg (NL); DINGEMANS, Gijs, NL-5021VX Tilburg (NL)
(74) Vertreter: Bakhtyari, Arash
(86) Internationale Anmeldenummer: PCT/DE2010/075045
(87) Internationale Veröffentlichungsnummer: WO 2010/145648

(56) Entgegenhaltungen:
- EP-A2- 1 635 398
- WO-A1-2008/065918
- DE-A1-102007 054 384
- US-A1- 2005 011 548
- HOEX B ET AL: "On the c-Si surface passivation mechanism by the negative-charge-dielectric Al2O3" JOURNAL OF APPLIED PHYSICS, AMERICAN INSTITUTE OF PHYSICS. NEW YORK, US LNKD- DOI:10.1063/1.3021091, Bd. 104, Nr. 11, 1. Dezember 2008 (2008-12-01), Seiten 113703-113703, XP012116651 ISSN: 0021-8979
- KESSELS W M M ET AL: "Electric field induced surface passivation of Si by atomic layer deposited Al2O3 studied by optical second-harmonic generation" PHOTOVOLTAIC SPECIALISTS CONFERENCE (PVSC), 2009 34TH IEEE, IEEE, PISCATAWAY, NJ, USA, 7. Juni 2009 (2009-06-07), Seiten 427-431, XP031626849 ISBN: 978-1-4244-2949-3
- HOFMANN M ET AL: "Recent developments in rear-surface passivation at Fraunhofer ISE", SOLAR ENERGY MATERIALS AND SOLAR CELLS, ELSEVIER SCIENCE PUBLISHERS, AMSTERDAM, NL, vol. 93, no. 6-7, 1 June 2009 (2009-06-01) , pages 1074-1078, XP026093572, ISSN: 0927-0248, DOI: 10.1016/J.SOLMAT.2008.11.056 [retrieved on 2009-01-25]
- SWATOWSKA B ET AL: "Amorphous hydrogenated silicon-nitride films for applications in solar cells", VACUUM, PERGAMON PRESS, GB, vol. 82, no. 10, 3 June 2008 (2008-06-03), pages 942-946, XP022669348, ISSN: 0042-207X, DOI: 10.1016/J.VACUUM.2008.01.004 [retrieved on 2008-01-05]
- VERLAAN ET AL: "Deposition of device quality silicon nitride with ultra high deposition rate (>7 nm/s) using hot-wire CVD", THIN SOLID FILMS, ELSEVIER, AMSTERDAM, NL, vol. 516, no. 5, 15 January 2008 (2008-01-15), pages 533-536, XP022492117, ISSN: 0040-6090, DOI: 10.1016/J.TSF.2007.06.111
- BUIE D ET AL: "Full day simulations of anti-reflection coatings for flat plate silicon photovoltaics", SOLAR ENERGY MATERIALS AND SOLAR CELLS, ELSEVIER SCIENCE PUBLISHERS, AMSTERDAM, NL, vol. 81, no. 1, 25 January 2004 (2004-01-25), pages 13-24, XP004482759, ISSN: 0927-0248, DOI: 10.1016/J.SOLMAT.2003.08.009

## Beschreibung

Die Erfindung betrifft eine Solarzelle und ein Herstellungsverfahren einer Solarzelle.

Eine der begrenzenden Faktoren für die Solarzelleneffizienz ist die Rekombination von Ladungsträgern an Halbleiteroberflächen von Solarzellen, welche die Rekombinationsaktivität begünstigende Oberflächenzustände aufweisen. Diese rekombinierten Ladungsträger stehen dann nicht mehr für die Stromerzeugung zur Verfügung. Um Rekombinationen zu vermindern, muss die Solarzellenoberfläche passiviert werden, indem die Rekombinationsaktivität von Ladungsträgern über Oberflächenzustände herabgesetzt werden.

Zur Oberflächenpassivierung gibt es grundsätzlich zwei unterschiedliche Ansätze, da die Rekombinationsaktivität zum einen mit der Anzahl bzw. Dichte der Oberflächenzustände und zum anderen mit der Ladungsträgerdichte skaliert, genauer mit dem Produkt aus Loch- und Elektronendichte. Somit kann zur Oberflächenpassivierung zum einen die Anzahl der Oberflächenzustände herabsetzen werden. Diese sogenannte chemische Passivierung wird mittels chemischer Absättigung freier Oberflächenbindungen (sogenannter dangling bonds) erreicht, bei Silizium-Halbleitersolarzellen beispielsweise mittels thermischen Aufwachsens einer Siliziumoxidschicht (SiO₂-Schicht). Die hierbei entstehende Grenzfläche zwischen dem Halbleiter und der SiO₂-Schicht zeichnet sich durch eine besonders geringe Dichte der genannten Oberflächenzustände aus. Für die Oberflächenpassivierung von Hocheffizienzsolarzellen wird in der Regel die chemische Passivierung verwendet.

Der zweite Ansatz zur Oberflächenpassivierung besteht darin, eine der Ladungsträgerarten (nämlich die positiven oder die negativen Ladungsträger) von den rekombinationsaktiven Zuständen an der Halbleiteroberfläche fernzuhalten, indem dort ein geeignetes Potential angelegt wird. Auf diese Weise stehen der jeweils anderen Ladungsträgerart nicht genügend Rekombinationspartner zur Verfügung. Diese sogenannte Feldeffektpassivierung ist Grundprinzip beispielsweise beim sogenannten Back-Surface-Field (BSF) aus Aluminium und beim Aufbringen dielektrischer Schichten, beispielsweise aus Siliziumnitrid (SiNₓ) oder Aluminiumoxid (Al₂O₃), die an ihren Grenzflächen zur Halbleiteroberfläche ortsfeste Oberflächenladungen ausbilden.

Beide der oben genannten Ansätze für die Oberflächenpassivierung haben den Nachteil, dass sie in der Regel für sich genommen keine ausreichende Passivierung erzielen. Beispielsweise muss eine mittels thermischer Oxidation erzeugte SiO₂-Schicht auf einer Siliziumoberfläche zusätzlich durch Wasserstoff angereichert werden, beispielsweise mittels sogenanntem Formiergas-Anneal oder Alneal. Ferner müssen Solarzellen nach der Oberflächenpassivierung noch weitere Verfahrensschritte bei der Herstellung durchlaufen. Zum einen muss daher die Oberflächenpassivierung bei diesen Verfahrensschritten stabil bleiben. Zum anderen muss die hierfür aufgebrachte Passivierungsschicht in der Regel auch zusätzliche Funktionalitäten aufweisen, wie beispielsweise als Diffusionsbarriere wirken. Oft führt diese zusätzliche Anforderung an die Passivierungsschicht zu einer Kompromisslösung mit suboptimaler Oberflächenpassivierung.

Bekannter Stand der Technik bilden die Dokumente Hoex et al., "On the c-Si surface passivation mechanics by the negative-charge-dielectric Al2O3", Journal of Applied Physics, Bd. 104, Nr. 11, 1.12.2008, S. 113703ff. und Hofmann et al., "Recent developments in rear surface passivation at Fraunhofer ISE", Solar Energy Materials and Solar Cells, Bd. 93, Nr. 6-7, 1.6.2009, S. 1074-1078.

Es ist daher Aufgabe der Erfindung, eine Solarzelle und ein Herstellungsverfahren einer Solarzelle bereitzustellen, um die Oberfläche der Solarzelle effektiv zu passivieren und zugleich die Gestaltungsvielfalt für die Optimierung weiterer Prozessschritte bei der Herstellung der Solarzelle zu erhöhen.

Die Aufgabe wird gemäß der Erfindung durch eine Solarzelle mit den Merkmalen des Anspruch 1 und durch ein Herstellungsverfahren mit den Merkmalen des Anspruchs 12 gelöst. Vorteilhafte Weiterbildungen der Erfindung sind in den Unteransprüchen aufgeführt.

Wie im Folgenden erläutert, kann mittels der Erfindung die Passivierungsqualität und die Stabilität der Passivierungsschicht verbessert werden. Zudem kann sich eine höhere Flexibilität im Hinblick auf die einstellbaren Verfahrensparameter ergeben. Die Erfindung beruht auf der Erkenntnis, dass das Bilden einer Passivierungsschicht aus zwei Passivierungsteilschichten mit unterschiedlichen Passivierungsmechanismen zur einer Verbesserung der Passivierungsqualität führen kann, die über eine bloße Kumulation der bekannten Einzeleffekte hinausgeht.

Mit der Bezeichnung der chemisch passivierenden Passivierungsteilschicht und der feldeffektpassivierenden Passivierungsteilschicht ist gemeint, dass der jeweilige Passivierungsmechanismus bei der zugehörigen Passivierungsteilschicht dominiert. Mit anderen Worten, die feldeffektpassivierende Passivierungsteilschicht kann, wenn sie unmittelbar auf einer Halbleiterschichtoberfläche angeordnet ist, durchaus eine chemisch passivierende Wirkung haben, wie dies beispielsweise bei Siliziumnitrid (SiNₓ) auf Silizium der Fall ist. Jedoch ist die feldeffektpassivierende Wirkung weitaus größer. Gleiches gilt bei der chemisch passivierenden Passivierungsteilschicht, welche eine wenn auch geringe Flächenladungsdichte aufweisen kann, wobei jedoch die chemisch passivierende Wirkung dominiert.

Vorteilhafterweise weist die feldeffektpassivierende Passivierungsteilschicht zumindest eine höhere Flächenladungsdichte auf, als die chemisch passivierende Passivierungsteilschicht. Bevorzugt ist die Flächenladungsdichte der feldeffektpassivierenden Passivierungsteilschicht zumindest etwa eine Größenordnung höher als die Flächenladungsdichte der chemisch passivierenden Passivierungsteilschicht.

Insbesondere sind die chemisch passivierende Passivierungsteilschicht und / oder die feldeffektpassivierende Passivierungsteilschicht jeweils aus einem Dielektrikmaterial gebildet.

Es sei an dieser Stelle darauf hingewiesen, dass der Effekt einer Feldeffektpassivierung nicht nur von der Flächenladungsdichte einer feldeffektpassivierenden Passivierungsteilschicht abhängt, sondern auch von der Ladungsträgerdichte und somit von der Dotierungsdichte und Dotierungsart der Halbleiterschicht, dessen Oberfläche passiviert werde soll. Ähnlich ist auch die Wirkung einer chemischen Passivierung nicht nur vom Material der chemisch passivierenden Passivierungsteilschicht abhängig, sondern in zum Teil erheblichem Maße auch von den Oberflächeneigenschaften der zu passivierenden Halbleiteroberfläche, insbesondere von ihrer Defektdichte. Diese kann zudem von der Art der Aufbringung der Passivierungsteilschichten abhängen. Beispielsweise kann die chemisch passivierende Passivierungsteilschicht abgeschieden sein, etwa mittels nasschemischer Verfahren oder mittels Abscheidung aus der Gasphase, oder Sie kann thermisch aufgewachsen sein.

Vorliegend werden also zwei unterschiedliche Passivierungseffekte für die Oberflächenpassivierung verwendet, die jedoch auf unterschiedliche Passivierungsteilschichten aufgeteilt und somit voneinander entkoppelt werden. Zusätzlich zu einer effektiveren Passivierung hat die zumindest aus einer chemisch passivierenden und einer feldeffektpassivierenden Passivierungsteilschicht gebildete Passivierungsschicht den Vorteil, eine höhere Stabilität zu besitzen, als lediglich eine Passivierungsschicht einer Passivierungsart. In der Regel durchlaufen Solarzellen während ihrer Herstellung nach dem Aufbringen der Oberflächenpassivierung eine Reihe weiterer Prozessschritte. Hierbei kann die Oberflächenpassivierung an Passivierqualität einbüßen. Mit einer Kombination der beiden Passivierungsteilschichten kann dieser Verlust an Passivierqualität vermindert oder ganz verhindert werden. Beispielsweise kann mittels der zweischichtigen Passivierung eine erhöhte Feuerstabilität erreicht werden, zum Beispiel für den Freuerprozess im Rahmen eines Siebdruckverfahrens.

Ein weiterer Vorteil ergibt sich aus folgender Überlegung: Manche chemisch passivierenden Passivierungsteilschichten passivieren die Halbleiterschichtoberfläche hauptsächlich mittels Absättigung sogenannter Dangling-Bonds. Dies ist beispielsweise bei thermisch gewachsenen SiO₂-Schichten auf Silizium der Fall. Insbesondere für SiO₂-Schichten ist bekannt, dass ein zusätzlicher Prozessschritt notwendig ist, um der Grenzfläche zwischen dem Halbleiter und der Passivierungsteilschicht zusätzlichen Wasserstoff zur Verfügung zu stellen, um eine ausreichend gute Oberflächenpassivierung zu erzielen. Ein typischer Prozessschritt hierfür ist beispielsweise das sogenannte Formiergas-Anneal oder Alneal, bei dem Aluminium bei erhöhter Temperatur mit SiO₂ reagiert und Wasserstoff freigesetzt wird.

Probleme können sich hierbei ergeben, beispielsweise aufgrund der Flüchtigkeit des Wasserstoffes, oder dadurch, dass ein Alneal überhaupt nicht realisiert werden kann, was beispielsweise bei Standardmetallisierungen mittels Siebdruckpasten der Fall sein könnte. Bei der hier beschriebenen Solarzelle hingegen wird nicht ausschließlich die chemische Passivierung ein und derselben Schicht verbessert, sondern die Passivierungsqualtät wird mit Hilfe einer zusätzlichen feldeffektpassivierenden Passivierungsteilschicht erhöht. Vorteilhaft ist es außerdem, wenn durch das Aufbringen beziehungsweise durch die Abscheidung der feldeffektpassivierenden Passivierungsteilschicht eine zusätzliche Wasserstoffpassivierung der Grenzfläche zwischen Halbleiterschichtoberfläche und Passivierungsschicht erfolgt. Dies geschieht beispielsweise, wenn auf einer chemisch passivierenden SiO₂-Schicht eine SiNₓ-Schicht aufgebracht wird.

Während der Herstellung der Solarzelle wird vorteilhafterweise zunächst die chemisch passivierende Passivierungsteilschicht unmittelbar auf die Halbleiterschichtoberfläche aufgebracht und anschließend die feldeffektpassivierende Passivierungsteilschicht unmittelbar auf die chemisch passivierende Passivierungsteilschicht abgeschieden. Alternativ kann es abschalten beziehungsweise das aufwachsen in der weiten Schichten an unterschiedlichen Stadien des Herstellungsprozesses stattfinden. Außerdem ist es von Vorteil, nach dem herstellen der Passivierungsschicht, diese einer Wärmebehandlung (Temperschritt) zu unterziehen.

Gemäß einer zweckmäßigen Ausgestaltung ist vorgesehen, dass die chemisch passivierende Passivierungsteilschicht zwischen der Halbleiterschicht und der feldeffektpassivierenden Passivierungsteilschicht auf der Halbleiterschichtoberfläche angeordnet ist. Mit anderen Worten, bei der Herstellung der Solarzelle wird nach dem Aufbringen der chemisch passivierenden Passivierungsteilschicht die feldeffektpassivierende Passivierungsteilschicht aufgebracht, wobei hierzwischen weitere Prozessschritte erfolgen können. Bei Verwendung der Solarzelle kann die feldeffektpassivierende Passivierungsteilschicht in diesem Fall durch die chemisch passivierende Passivierungsteilschicht hindurch auf die Halbleiterschichtoberfläche Einfluss nehmen und dort Ladungsträger in den Halbleiter hinein abstoßen.

In einer vorteilhaften Ausgestaltung des Herstellungsverfahren ist vorgesehen, dass vor dem Aufbringen der feldeffektpassivierenden Passivierungsteilschicht die aufgebrachte chemisch passivierende Passivierungsteitschicht in einem Diffusionsprozess als Diffusionsbarriere, in einem Ätzprozess als Ätzbarriere und / oder in einem Texturprozess als Texturbarriere verwendet wird. Da es sich bei der Passivierungsschicht um eine Rückseitenpassivierung handelt, kann die chemisch passivierende Passivierungsteilschicht als Diffusionsbarriere beim Aufbringen einer rückseitigen dielektrischen Schicht wirken.

Neben den hier genannten Funktionen kann die chemisch passivierende Passivierungsteilschicht gegebenenfalls weitere funktionale Aufgaben während des Solarzellen-Herstellungsprozesses erfüllen, um zum Beispiel die Kosten und den Aufwand für ansonsten notwendige funktionsspezifische Zwischenschichten oder Opferschichten einzusparen. Die vorangehend erläuterte entkoppelte Anwendung der beiden Passivierungsmechanismen Feldeffekt- und chemische Passivierung mit Hilfe zweier Passivierungsteilschichten erlaubt eine größere Parameterauswahl, indem die chemisch passivierende Passivierungsteilschicht Eigenschaften mit sich bringt, welche die genannten zusätzlichen Funktionalitäten im Solarzellen-Herstellungsprozess fördern, während die weitere, feldeffektpassivierende Passivierungsteilschicht die Oberflächenpassivierung mittels Ausbildung eines Feldeffektes erhöht.

Bei einer bevorzugten Ausführungsform ist vorgesehen, dass die chemisch passivierende Passivierungsteilschicht unmittelbar an der feldeffektpassivierenden Passivierungsteilschicht angrenzt. Hierbei wird also die feldeffektpassivierende Passivierungsteilschicht im Anschluss auf das Aufbringen der chemisch passivierenden Passivierungsteilschicht aufgebracht, ohne weitere Zwischenschichten hierzwischen anzuordnen. Es ist trotzdem denkbar, dass vor dem Aufbringen der feldeffektpassivierenden Passivierungsteilschicht weitere Prozessschritte an der Solarzelle beziehungsweise an der chemisch passivierenden Passivierungsteilschicht vorgenommen werden, beispielsweise ein Reinigungsschritt.

In einer vorteilhaften Weiterbildung ist vorgesehen, dass zwischen der chemisch passivierenden Passivierungsteilschicht und der feldeffektpassivierenden Passivierungsteilschicht eine Zwischenschicht angeordnet ist. Die Zwischenschicht kann dazu dienen, elektrische, optische und / oder mechanische Eigenschaften der Passivierungsschicht oder die Verbindung zwischen den beiden Passivierungsteilschichten zu beeinflussen beziehungsweise zu optimieren. Beispielsweise kann zwischen einer chemisch passivierenden Passivierungsteilschicht aus SiO₂ und einer feldeffektpassivierenden Passivierungsteilschicht aus Al₂O₃ eine gegenüber beiden preiswertere SiOₓ-Zwischenschicht erzeugt werden, um die Reflexionseigenschaften der Passivierungsschicht zu beeinflussen.

Kumulativ oder alternativ hierzu kann auch vorgesehen seien, auf der feldeffektpassivierenden Passivierungsteilschicht eine weitere Schicht zur Anpassung oder Modifizierung der Passivierungsschicht vorzusehen.

Bevorzugterweise ist vorgesehen, dass zumindest eine der Passivierungsteilschichten pinholefrei gebildet ist. Dies ist insbesondere bei sich überlappenden Metallisierungen in mehreren Metallisierungsebenen bei rückseitenkontaktierenden Solarzellen von Vorteil, um die Gefahr von Kurzschlüssen zu vermindern. Wenngleich es ausreichend sein kann, wenn nur eine der Passivierungsteilschichten pinholefrei ist, gilt dies vorteilhafterweise sowohl für die chemisch passivierende Passivierungsteilschicht als auch für die feldeffektpassivierende Passivierungsteilschicht.

Bei einer zweckmäßigen Ausführungsform ist vorgesehen, dass die feldeffektpassivierende Passivierungsteilschicht mittels Atomlagenabscheidung (kurz ALD - "atomic layer deposition"), vorzugsweise thermische ALD, mittels physikalischer oder chemischer Gasphasenabscheidung (PVD oder CVD), gegebenenfalls Plasma-unterstützt (PECVD), oder mittels Sol-Gel-Verfahren gebildet ist. Mit ALD lassen sich insbesondere aus Aluminiumoxid besonders gleichmäßige und vollständige Schichten bilden. Zudem kann die Schichtdicke sehr genau eingestellt werden, im Idealfall bis auf eine atomare Schicht genau. Sowohl für das Aufbringen der chemisch passivierenden Passivierungsteilschicht als auch der feldeffektpassivierenden Passivierungsteilschicht lassen sich jedoch unabhängig voneinander weitere bekannte Verfahren einsetzen, beispielsweise chemische oder physikalische Abscheideverfahren. Jedoch ist die Qualität der chemisch passivierende Passivierungsteilschicht nicht in dem Maße kritisch, wie die der feldeffektpassivierenden Passivierungsteilschicht, so dass erstere mittels preiswerterer Verfahren wie CVD, nasschemischer Oxidation, PVD (beispielsweise Sputtern oder Aufdampfen) erzeugt werden kann.

In einer vorteilhaften Ausgestaltung ist vorgesehen, dass die feldeffektpassivierende Passivierungsteilschicht eine Dicke in einem Bereich zwischen 0,1 und 10 nm, vorzugsweise zwischen 2 und 5 nm aufweist. Auch dickere Schichten bis 100 nm und mehr sind denkbar. Dies ist mitunter abhängig von den Kosten des Abscheideverfahrens, die beispielsweise bei ALD deutlich höher liegen als bei anderen Verfahren, wie bei der plasmaunterstützten chemischen Gasphasenabscheidung (PECVD) möglich ist. In einer bevorzugten Ausführungsform liegt die Dicke der feldeffektpassivierenden Passivierungsteilschicht zwischen etwa 10 und etwa 15 nm.

Erfindungsgemäß ist vorgesehen, dass die Passivierungsschicht als Reflexionsschicht ausgebildet ist. Während eine erfindungsgemäße Funktion der Passivierungsschicht als Reflexionsschicht für infrarotes Licht auf der dem einfallenden Licht abgewandten Solarzellenrückseite von Vorteil ist, ist eine als Anti-Reflexionsschicht ausgebildete Passivierungsschicht auf der Solarzellenvorderseite wünschenswert. Um die Passivierungsschicht als Reflexionsschicht oder als Anti-Reflexionsschicht auszubilden, können die Schichtdicken und / oder die optischen Eigenschaften der beiden Passivierungsteilschichten unabhängig voneinander gewählt werden.

Vorteilhafterweise ist vorgesehen, dass das feldeffektpassivierende Material oder die feldeffektpassivierende Passivierungsteilschicht im Wesentlichen aus einem Material mit einer Flächenladungsdichte von mindestens 10¹² cm⁻², vorzugsweise von mindestens 5x10¹² cm⁻², bevorzugt von mindestens 10¹³ cm⁻² gebildet ist. Es kann sich hierbei um eine positive oder um eine negative Flächenladungsdichte handeln.

In einer vorteilhaften Ausgestaltung ist vorgesehen, dass die feldeffektpassivierende Passivierungsteilschicht im Wesentlichen aus einem Material mit einer negativen Flächenladungsdichte gebildet ist. Eine Reihe von Materialien, die zur Herstellung von in erster Linie chemisch passivierenden Passivierungsschichten geeignet sind, weisen geringe positive Flächenladungsdichten auf. Dies gilt beispielsweise bei der Verwendung auf Siliziumhalbleitern für amorphe Siliziumschichten (a-Si-Schichten) sowie SiO₂-Schichten. So hat zum Beispiel eine thermisch gewachsene SiO₂-Schicht eine typische Flächenladungsdichte von etwa 10¹¹ cm⁻². Diese positive Flächenladungsdichte kann sich bei p-dotierten Halbleiterschichten nachteilig auswirken. Beispielsweise kann die Qualität einer Passivierung mittels einer SiO₂-Schicht von der Injektionsdichte photogenerierter Überschussladungsträger abhängig sein, was wiederum einen negativen Einfluss auf die Effizienz der Solarzelle haben kann.

Mittels der zusätzlichen feldeffektpassivierenden Passivierungsteilschicht mit negativer Flächenladungsdichte kann der Effekt der viel geringeren positiven Flächenladungsdichte der darunterliegenden Passivierungsteilschicht vermindert oder sogar umgekehrt werden, indem die effektive Flächenladungsdichte der gesamten Passivierungsschicht quantitativ geändert und / oder sogar ihre Polarität umkehrt wird. Ein derartiger Effekt kann allgemeiner formuliert dann genutzt werden, wenn die viel größere Flächenladungsdichte der feldeffektpassivierenden Passivierungsteilschicht ein anderes Vorzeichen hat, als eine gegebenenfalls vorhandene Flächenladungsdichte der chemisch passivierenden Passivierungsteilschicht.

Aus der Wirkung der Flächenladungsdichte der feldeffektpassivierenden Passivierungsteilschicht ergibt sich je nach Polarität der als Basis wirkenden Halbleiterschicht und der Flächenladungsdichte der Passivierungsteilschichten ein weiterer bedeutender Vorteil: Bei chemisch passivierenden Schichten mit einer geringen positiven Flächenladungsdichte, welche auf eine p-dotierte oder p-Typ Halbleiterschicht aufgebracht werden, kann sich, je nach Verhältnis zwischen Halbleiterdotierung und Flächenladungsdichte, eine Inversionsschicht auf der Halbleiteroberfläche ausbilden. Entsprechendes ist der Fall bei einer n-dotierten oder n-Typ Halbleiterschicht, auf der eine chemisch passivierende Schicht mit negativer Flächenladungsdichte angeordnet ist. Bei punktkontaktierten Solarzellen bildet sich zwischen den Punktkontakten ein Inversionskanal, welcher eine bekannte Quelle von Ladungsträger- und somit Wirkungsgradverlusten darstellt. Indem, wie hier vorgeschlagen, auf die chemisch passivierende Schicht eine feldeffektpassivierende Passivierungsteilschicht aufgebracht wird, kann dieses Problem vermieden werden. Hierzu kann beispielsweise bei Verwendung einer p-Typ Halbleiterschicht eine feldeffektpassivierende Passivierungsteilschicht mit hoher negativer Flächenladungsdichte, beispielsweise eine Al₂O₃-Schicht eingesetzt werden.

Gemäß einer bevorzugten Ausgestaltung ist vorgesehen, dass die feldeffektpassivierende Passivierungsteilschicht Aluminiumoxid, Aluminiumfluorid, Siliziumnitrid, Aluminiumoxynitrid und / oder einer anderen Verbindung aus Aluminiumoxid oder Aluminiumoxynitrid (AlₓO_{y}N_{z}) und einem oder mehreren weiteren Elementen umfasst. Bei Aluminiumoxid (AlOₓ oder Al₂O₃) und Aluminiumfluorid (AlF₃) handelt es sich um Materialien, die eine feldeffektpassivierende Passivierungsteilschicht mit einer negativen Flächenladungsdichte bilden, während eine Passivierungsteilschicht aus Siliziumnitrid eine positive Flächenladungsdichte aufweist. Bei den weiteren Elementen kann es sich beispielsweise um Metalle, insbesondere Seltenerdmetalle, oder um Kohlenstoff handeln.

Bevorzugterweise ist vorgesehen, dass die chemisch passivierende Passivierungsteilschicht ein amorphes Halbleitermaterial oder ein Halbleiteroxid umfasst. Beispielsweise kann es sich hierbei um eine Schicht aus amorphem Silizium oder um eine SiO₂-Schicht handeln, die für eine chemische Passivierung von Silizium-Halbleiterschichten geeignet sind. Ein Halbleiteroxid kann auf der Halbleiterschicht entweder mittels eines Abscheideverfahrens oder mittels Oxidation der Halbleiterschichtoberfläche erzeugt werden.

Vorteilhafterweise ist die chemisch passivierende Passivierungsteilschicht aus einer Verbindung aus Silizium mit Sauerstoff, Stickstoff und / oder Kohlenstoff gebildet. Insbesondere eignen sich als Material für die chemisch passivierende Passivierungsteilschicht Siliziumoxinitride (SiOₓN_{y}) oder Siliziumoxinitricarbide(SiOₓN_{y}C_{z}). Durch geeignete Auswahl der Materialien für die Passivierungsteilschichten lassen sich Passivierungsschichten erzeugen, welche während der Solarzellenherstellung funktionale Aufgaben übernehmen, beispielsweise als Ätz-, Textur- und / oder Diffusionsbarrieren dienen. Alternativ oder zusätzlich kann auch die chemisch passivierende Passivierungsteilschicht alleine eine derartige Funktion im Prozessfluss übernehmen.
In einer zweckmäßigen Weiterbildung ist vorgesehen, dass sich die Passivierungsschicht über im Wesentlichen die gesamte Halbleiterschichtoberfläche erstreckt. Hierbei können jedoch in der Passivierungsschicht Durchbrüche oder Durchgänge für die Verschaltung der Solarzelle gebildet sein. Außerdem können Randbereiche der Solarzelle aus technischer Notwendigkeit frei liegen.

Zweckmäßigerweise ist eine beidseitige Passivierung mittels der Passivierungsschicht vorgesehen. Die Passivierungsschichten können auf der Solarzellenvorderseite und auf der Solarzellenrückseite die gleichen Merkmale und Eigenschaften haben. Alternativ können sie den jeweiligen Notwendigkeiten angepasst auch unterschiedlich ausgebildet sein. Insbesondere ist es bei Ausbildung der Passivierungsschicht mit zusätzlichen optischen Eigenschaften zweckmäßig, die vorderseitige Passivierungsschicht als Anti-Reflexionsschicht für das relevante Lichtspektrum zu gestalten.

Gemäß einer bevorzugten Ausführungsform weist die Passivierungsschicht insgesamt an der Halbleiterschichtoberfläche eine Grenzflächenladungsdichte von höchstens 10¹³ cm⁻², höchstens 10¹² cm⁻² oder höchstens 10¹¹ cm⁻² auf. Insbesondere haben sich Grenzflächenladungsdichten von etwa 5x10¹¹ cm⁻² zur Passivierung sowohl von n-Typ als auch von p-Typ Halbleiterschichten als vorteilhaft erwiesen.

Es ist also darauf hinzuweisen, dass sich die hohe Flächenladungsdichte der feldeffektpassivierenden Passivierungsteilschicht nicht unbedingt direkt in der Flächenladungsdichtewerte der Passivierungsschicht widerspiegelt. Aufgrund der Kombination der feldeffektpassivierenden Passivierungsteilschicht mit der chemisch passivierenden Passivierungsteilschicht kann somit eine Passivierungsschicht mit sehr hoher Passivierqualität entstehen, die insgesamt eine eher niedrige Flächenladungsdichte aufweist. Eine derartige Passivierungsschicht eignet sich sowohl auf n-Typ als auch auf p-Typ Halbleiterschichten, ohne eine Inversionskanal auszubilden.

Die maximal tolerierbare Grenzflächenladungsdichte der gesamten Passivierungsschicht kann abhängig vom Material und von der Dotierung der Halbleiterschicht nahe der Halbleiterschichtoberfläche sein. Die oben angegebenen bevorzugten Maximalwerte beziehen sich auf Halbleiterschichten mit dotierter Si-Oberfläche (Oberflächenkonzentration von etwa 1x10¹⁹ bis 6x10²⁰ cm⁻²).

Gemäß einer zweckmäßigen Ausführungsform weist die chemisch passivierende Passivierungsteilschicht eine Schichtdicke von mindestens 1 nm, 5 nm, 10 nm, 50 nm oder 100 nm auf. Je dicker die chemisch passivierende Passivierungsteilschicht ist, desto weiter entfernt ist die feldeffektpassivierende Passivierungsteilschicht von der Halbleiterschichtoberfläche entfernt, so dass die Grenzflächenladungsdichte geringer ausfällt. Zumindest bei einer nasschemischen Abscheidung der chemisch passivierenden Passivierungsteilschicht, kann auch eine Schichtdicke, von etwa 1 bis 5 nm von Vorteil sein.

In zweckmäßigen Ausführungsformen sind die chemisch passivierende Passivierungsteilschicht und / oder die feldeffektpassivierende Passivierungsteilschicht als Niedrigtemperaturschicht aufgebracht. Insbesondere werden beide Schichten bei einer Temperatur von unter 400°C aufgebracht.

Die Erfindung wird im Folgenden anhand von Ausführungsbeispielen unter Bezugnahme auf die Figuren erläutert. Hierbei zeigen:
- Fig. 1a bis 1e: schematische Querschnittsansichten auf eine Solarzelle in unterschiedlichen Stadien eines Herstellungsverfahrens gemäß einer bevorzugten Ausführungsform; und
- Fig. 2: eine schematische Querschnittsansicht einer Solarzelle, die mittels des in den Fig. 1a bis 1e veranschaulichten Verfahrens hergestellt wurde.

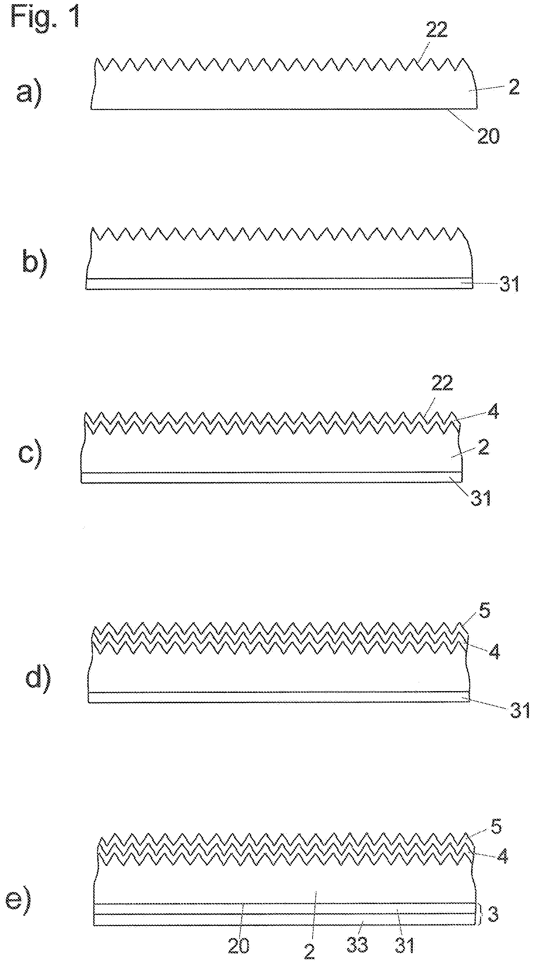

Anhand der Fig. 1a bis 1e wird im Folgenden die Herstellung einer Solarzelle 1 mit beidseitiger Oberflächenpassivierung gemäß einer möglichen Ausführungsform beschrieben. Die Fig. 1a zeigt einen Querschnitt einer Halbleiterschicht 2, mit einer Halbleiterschichtoberfläche 20, welche hier eine lichtabgewandte Solarzellenrückseite 20 bildet, und einer weiteren Halbleiterschichtoberfläche 22, welche hier eine lichtzugewandte Solarzellenvorderseite 22 bildet. Die Halbleiterschichtoberfläche 20 ist zur Wirkungsgradsteigerung vorzugsweise texturiert, was in den Figuren als Sägezahnmusterung dargestellt ist.

Auf der Halbleiterschichtoberfläche 20 wird gemäß der Fig. 1b eine chemisch passivierende Passivierungsteilschicht 31 aufgebracht, welche darüber hinaus bei einem folgenden Dotierschritt zum Dotieren der weiteren Halbleiterschichtoberfläche 22 als Diffusionsbarriere dienen kann. Nach dem Dotierschritt erhält man die Anordnung aus der Fig. 1c, bei der die weitere Halbleiterschichtoberfläche 22 mit einer Dotierschicht 4 versehen ist, die mit der restlichen Halbleiterschicht 2 einen pn-Übergang bildet. Die weitere Halbleiterschichtoberfläche 22 wird anschließend mittels einer auf die Dotierschicht 4 aufgebrachte weitere Passivierungsschicht 5 gemäß der Fig. 1d passiviert.

Daraufhin wird auf der chemisch passivierenden Passivierungsteilschicht 31 eine feldeffektpassivierende Passivierungsteilschicht 33 aufgebracht. Hierdurch entsteht die in der Fig. 1e dargestellte Passivierungsschicht 3 auf der Halbleiterschichtoberfläche 20, welche die rückseitige Solarzellenoberfläche bildet. Aus diesem Grunde ist es vorteilhaft, mittels geeigneter Wahl der physikalischen Eigenschaften und der Abscheidungsparameter der Passivierungsteilschichten 31, 33 eine Passivierungsschicht 3 zu erzeugen, welche zugleich als rückseitige Reflexionsschicht für das bei der jeweiligen Solarzelle relevante Lichtspektrum dient. Hierzu kann, anders als in der Fig. 1e gezeigt, eine zusätzliche Zwischenschicht zwischen den Passivierungsteilschichten 31, 33 angeordnet werden.

Bei der weiteren Passivierungsschicht 5 kann es sich um eine konventionelle Passivierungsschicht handeln, welche mittels einer einzelnen chemisch passivierenden oder feldeffektpassivierenden Schicht gebildet ist. Alternativ kann auch die weiteren Passivierungsschicht 5 aus einer Kombination zweier Passivierungsteilschichten entsprechend der Passivierungsschicht 3 zusammengesetzt sein.

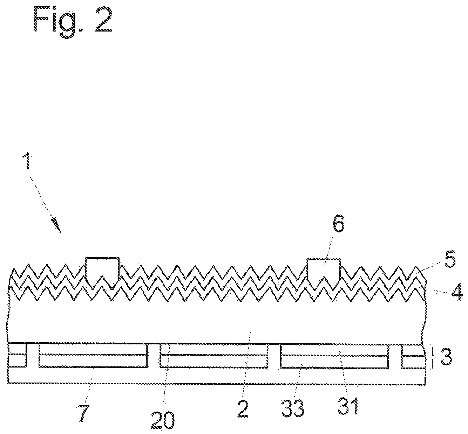

Um eine Verschaltung der Solarzelle 1 zu ermöglichen, müssen schließlich jeweils Zugänge zu der Halbleiterschicht 2 und der Dotierschicht 4 hergestellt und die Solarzelle 1 rückseitig und vorderseitig metallisiert werden, beispielsweise mittels Siebdruckverfahren mit anschließendem Feuerprozess. Hierzu werden in der Passivierungsschicht 3 und der weiteren Passivierungsschicht 5 Durchbrüche erzeugt. Als Ergebnis erhält man nach den Metallisierungsschritten die Solarzelle 1 entsprechend der Fig. 2. Auf der Solarzellenrückseite 20 kann die Metallisierung ganzflächig erfolgen, um einen Rückseitenkontakt 7 zu erzeugen, während sie auf der Solarzellenvorderseite 22 Vorderseitenkontakte 6 bildet, die vorzugsweise fingerförmig ausgebildet sind.

Bei der Halbleiterschicht 2 kann es sich beispielsweise um eine Schicht aus kristallinem Silizium in Form eines Siliziumwafers handeln, wobei in diesem Fall die chemisch passivierende Passivierungsteilschicht 31 aus thermisch ausgewachsenem oder mittels PECVD erzeugtem SiO₂ oder aus amorphem Silizium (a-Si) gebildet sein kann. Die feldeffektpassivierende Passivierungsteilschicht 33 ist beispielsweise aus Al₂O₃ gebildet.

Die Abscheidung oder das Wachsen der beiden Passivierungsteilschichten 31, 33 kann an unterschiedlichen Stadien des Herstellungsprozesses stattfinden. Dadurch können Funktionalitäten der chemisch passivierenden Passivierungsteilschicht 31 im Herstellungsprozess ausgenutzt werden. Entscheidend und nicht selbstverständlich ist hierbei, dass sich Flächenladungen der feldeffektpassivierenden Passivierungsteilschicht 33 auch beim Abscheiden auf die chemisch passivierende Passivierungsteilschicht 31 ausbilden, bei der es sich um ein Dielektrikum handelt. Dies ist insbesondere bei der Al₂O₃-Schicht auf der SiO₂-Schicht der Fall. Da zurzeit die besten Ergebnisse für Al₂O₃-Passivierungsschichten mittels ALD erzielt werden, ist ALD das bevorzugte Abscheideverfahren.

Es können jedoch durchaus auch andere Abscheideverfahren verwendet werden, beispielsweise PECVD, insbesondere wenn sie in dem vorliegenden Herstellungsverfahren mit den beiden Passivierungsteilschichten ähnlich gute Ergebnisse liefern wie ALD. Aus Kostengründen ist dann die Abscheidung mittels PECVD sogar vorzuziehen.

Zusätzlich bietet diese Schichtkombination aus den beiden Passivierungsteilschichten 31, 33 für eine industrielle Anwendung deutliche Vorteile. Die meisten gegenwärtig in der Labor-Entwicklung befindlichen Herstellungsverfahren für Hocheffizienz-Solarzellen verwenden eine thermisch erzeugte SiO₂-Schicht, die Übertragung dieses Herstellungsverfahrens auf industriell mittels Siebdruck hergestellte Solarzellen gestaltet sich jedoch schwierig. Dies liegt zum einen an der geringen Stabilität der SiO₂-Schicht gegenüber beim Siebdruck notwendigen Feuerprozessen, zum anderen daran, dass für eine sehr gute Passivierung in der SiO₂-Schicht Wasserstoff benötigt wird. Bei im Labor erzeugten Solarzellen wirkt eine mittels physikalischer Gasphasenabscheidung (PVD) aufgebrachte Aluminiumschicht als Wasserstoff-Spender. In der industriellen Fertigung hat jedoch der Siebdruck gegenüber PVD-Verfahren große Aufwands- und Kostenvorteile.

Aufgrund der Kombination zweier Passivierungseffekte ist die Dichte der Oberflächenzustände nicht mehr allein für die Passivierqualität ausschlaggebend. Die Schicht passiviert also nach dem Feuerprozess immer noch ausreichend, trotz erhöhter Anzahl an Oberflächenzuständen. Da außerdem die ohnehin sehr gute Passivierqualität der thermisch aufgewachsenen SiO₂-Schicht mittels Aufbringen der Al₂O₃-Schicht noch weiter erhöht wird, ist diese Anordnung auch für jene Hocheffizienzsolarzellen interessant, die in der Herstellung nicht einem Feuerprozess unterworfen werden.

Ein weiterer wichtiger Vorteil bei jeder Art der Kombination aus chemisch passivierender Passivierungsteilschicht 31 und feldeffektpassivierender Passivierungsteilschicht 33 zu einer Passivierungsschicht 3 ist die geringere Anforderung an die Güte der chemischen Passivierung, insbesondere bei thermisch aufgewachsenen Halbleiteroxiden. Dies ergibt sich daraus, dass für die Passivierqualität nicht mehr allein die Anzahl der Oberflächenzustände entscheidend ist. Deshalb werden für eine sehr gute Passivierung keine trocken gewachsenen Oxide mehr benötigt, und sogar mittels PECVD erzeugte Oxidschichten gewinnen an Bedeutung. Der Vorteil hierbei ist, dass ein Hochtemperaturschritt der thermischen Oxidation durch einen Niedertemperaturschritt einer PECVD-Abscheidung ersetzt wird, was unter anderem geringere Ansprüche an das Material der Solarzelle 1 stellt.

Schließlich gewinnt man durch die unterschiedlich wirkenden Passivierungsteilschichten 31, 33 Flexibilität im Herstellungsprozess. Beispielsweise können die Passivierungsteilschichten 31, 33 an unterschiedlichen Punkten im Herstellungsprozess gebildet werden und gegebenenfalls zusätzliche Funktionen übernehmen, beispielsweise kann die SiO₂-Schicht als Diffusionsbarriere wirken, zum Beispiel für eine Phosphordiffusion.

Die Solarzellen 1 in den hier dargestellten Ausführungsformen weisen jeweils nur auf einer Seite eine zweilagige Passivierungsschicht 3 auf. Alternativ kann die Passivierungsschicht 3 aus der chemisch passivierenden Passivierungsteilschicht 31, beispielsweise aus nasschemisch oder thermisch aufgewachsenem Siliziumoxid, und der feldeffektpassivierenden Passivierungsteilschicht 33, beispielsweise aus Aluminiumoxid, auf beiden Halbleiterschichtoberflächen 20, 22 aufgebracht sein. Anders ausgedrückt, kann es sich bei der weiteren Passivierungsschicht 5 ebenfalls um eine zweilagige Passivierungsschicht 3 handeln. Eine auf der Passivierungsschicht 3 aufgebrachte Deckschicht aus Siliziumnitrid (SiNₓ) kann ebenfalls auf beiden Seiten der Solarzelle aufliegen.

### Bezugszeichenliste:

- 1: Halbleitervorrichtung (Solarzelle)

- 2: Halbleiterschicht
- 20: Halbleiterschichtoberfläche, Solarzellenrückseite
- 22: weitere Halbleiterschichtoberfläche, Solarzellenvorderseite

- 3: Passivierungsschicht
- 31: chemisch passivierende Passivierungsteilschicht
- 33: feldeffektpassivierende Passivierungsteilschicht

- 4: Dotierschicht
- 5: weitere Passivierungsschicht
- 6: Vorderseitenkontakt
- 7: Rückseitenkontakt

## Patentansprüche

1. Solarzelle (1) mit einer Halbleiterschicht (2) und einer auf einer Oberfläche der Halbleiterschicht (2) angeordneten Passivierungsschicht (3) zur Passivierung der Halbleiterschichtoberfläche (20), wobei die Passivierungsschicht (3) eine auf einer lichtabgewandten Solarzellenrückseite der Solarzelle (1) angeordnete Rückseitenpassivierung ist, als Reflexionsschicht für infrarotes Licht ausgebildet ist und eine chemisch passivierende Passivierungsteilschicht (31) und eine feldeffektpassivierende Passivierungsteilschicht (33) umfasst, welche auf der Halbleiterschichtoberfläche (20) übereinander angeordnet sind, wobei die chemisch passivierende Passivierungsteilschicht (31) zwischen der Halbleiterschicht (2) und der feldeffektpassivierenden Passivierungsteilschicht (33) auf der Halbleiterschichtoberfläche (20) angeordnet ist und wobei eine Deckschicht aus Siliziumnitrid auf der Passivierungsschicht (3) aufgebracht ist.

2. Solarzelle (1) nach Anspruch 1, **dadurch gekennzeichnet, dass** zwischen der chemisch passivierenden Passivierungsteilschicht (31) und der feldeffektpassivierenden Passivierungsteilschicht (33) eine Zwischenschicht angeordnet ist.

3. Solarzelle (1) nach einem der Ansprüche 1 bis 2, **dadurch gekennzeichnet, dass** die feldeffektpassivierende Passivierungsteilschicht (33) eine atomlagenabgeschiedene, eine CVD-abgeschiedene, eine PECVDabgeschiedene, eine PVD-abgeschiedene Schicht oder eine Sol-Gel-Schicht ist.

4. Solarzelle (1) nach einem der Ansprüche 1 bis 3, **dadurch gekennzeichnet, dass** die feldeffektpassivierende Passivierungsteilschicht (33) eine Dicke in einem Bereich zwischen 0,1 und 10 nm, zwischen 2 und 5 nm, oder zwischen 10 und 15 nm aufweist.

5. Solarzelle (1) nach einem der vorangehenden Ansprüche, **dadurch gekennzeichnet, dass** das feldeffektpassivierende Material oder die feldeffektpassivierende Passivierungsteilschicht (33) im Wesentlichen aus einem Material mit einer Flächenladungsdichte von mindestens 10¹² cm⁻², vorzugsweise von mindestens 5x10¹² cm⁻², bevorzugt von mindestens 10¹³ cm⁻² gebildet ist.

6. Solarzelle (1) nach einem der vorangehenden Ansprüche, **dadurch gekennzeichnet, dass** die feldeffektpassivierende Passivierungsteilschicht (33) Aluminiumoxid, Aluminiumfluorid, Siliziumnitrid, Aluminiumoxynitrid und / oder eine andere Verbindung aus Aluminiumoxid und einem oder mehreren weiteren Elementen umfasst.

7. Solarzelle (1) nach einem der vorangehenden Ansprüche, **dadurch gekennzeichnet, dass** die chemisch passivierende Passivierungsteilschicht (31) ein amorphes Halbleitermaterial oder ein Halbleiteroxid umfasst.

8. Solarzelle (1) nach einem der vorangehenden Ansprüche, **dadurch gekennzeichnet, dass** die chemisch passivierende Passivierungsteilschicht (31) aus einer Verbindung aus Silizium mit Sauerstoff, Stickstoff und / oder Kohlenstoff gebildet ist.

9. Solarzelle (1) nach einem der vorangehenden Ansprüche, **gekennzeichnet durch** eine beidseitige Passivierung mittels der Passivierungsschicht (3).

10. Solarzelle (1) nach einem der vorangehenden Ansprüche, **dadurch gekennzeichnet, dass** die Passivierungsschicht (3) an der Halbleiterschichtoberfläche (20) eine Grenzflächenladungsdichte von höchstens 10¹³ cm⁻², höchstens 10¹² cm⁻² oder höchstens 10¹¹ cm⁻² aufweist.

11. Solarzelle (1) nach einem der vorangehenden Ansprüche, **dadurch gekennzeichnet, dass** chemisch passivierende Passivierungsteilschicht (31) eine Schichtdicke von mindestens 1 nm, 5 nm, 10 nm, 50 nm oder 100 nm aufweist.

12. Herstellungsverfahren einer Solarzelle (1), **dadurch gekennzeichnet, dass** eine chemisch passivierende Passivierungsteilschicht (31) und eine feldeffektpassivierende Passivierungsteilschicht (33) nacheinander auf einer Halbleiterschichtoberfläche (20) der Solarzelle (1) derart aufgebracht werden, dass die chemisch passivierende Passivierungsteilschicht (31) zwischen der Halbleiterschicht (2) und der feldeffektpassivierenden Passivierungsteilschicht (33) auf der Halbleiterschichtoberfläche (20) angeordnet ist, um gemeinsam eine als Reflexionsschicht für infrarotes Licht ausgebildete Passivierungsschicht (3) zu bilden, welche eine auf einer lichtabgewandten Solarzellenrückseite der Solarzelle (1) angeordnete Rückseitenpassivierung ist, wobei eine Deckschicht aus Siliziumnitrid auf der Passivierungsschicht (3) aufgebrachte wird.

13. Herstellungsverfahren nach Anspruch 12, **dadurch gekennzeichnet, dass** vor dem Aufbringen der feldeffektpassivierenden Passivierungsteilschicht (33) die aufgebrachte chemisch passivierende Passivierungsteilschicht (31) in einem Diffusionsprozess als Diffusionsbarriere, in einem Ätzprozess als Ätzbarriere und / oder in einem Texturprozess als Texturbarriere verwendet wird.

## Claims

1. A solar cell (1) having a semiconductor layer (2) and a passivation layer (3) arranged on a surface of the semiconductor layer (2) and for passivating the semiconductor layer surface (20), wherein the passivation layer (3) is a backside passivation arranged on a solar cell backside of the solar cell (1) not facing light, is formed as reflection layer for infrared light and comprises a chemically passivating passivation sublayer (31) and a field effect passivating passivation sublayer (33), which are arranged one above the other on the semiconductor layer surface (20), wherein the chemically passivating passivation sublayer (31) is arranged between the semiconductor layer (2) and the field effect passivating passivation sublayer (33) on the semiconductor layer surface (20) and wherein a cover layer of silicon nitride is deposited on the passivation layer (3).

2. The solar cell (1) according to claim 1, **characterized in that** an intermediate layer is arranged between the chemically passivating passivation sublayer (31) and the field effect passivating passivation sublayer (33).

3. The solar cell (1) according to one of claims 1 to 2, **characterized in that** the the field effect passivating passivation layer (33) is a layer formed by atomic layer deposition, CVD deposition, PECVD deposition, PVD deposition or by sol-gel method.

4. The solar cell (1) according to one of claims 1 to 3, **characterized in that** the field effect passivating passivation sublayer (33) has a thickness in a range between 0.1 and 10 nm, between 2 and 5 nm or between 10 and 15 nm.

5. The solar cell (1) according to one of claims, **characterized in that** the field effect passivating material or the field effect passivating passivation sublayer (33) is made substantially of a material having a surface charge density of at least 10¹² cm⁻², preferably at least 5x10¹² cm⁻², preferably at least 10¹³ cm⁻².

6. The solar cell (1) according to one of the preceding claims, **characterized in that** the field effect passivating passivation sublayer (33) comprises aluminum oxide, aluminum fluoride, silicon nitride, aluminum oxynitride, and / or another compound of aluminum oxide an one or several further elements.

7. The solar cell (1) according to one of the preceding claims, **characterized in that** the chemically passivating passivation layer (31) comprises an amorphous semiconductor material or a semiconductor oxide.

8. The solar cell (1) according to one of the preceding claims, **characterized in that** the chemically passivating passivation layer (31) is made of a compound of silicon with oxygen, nitrogen and /or carbon.

9. The solar cell (1) according to one of the preceding claims, **characterized by** passivation on both sides by means of the passivation layer (3).

10. The solar cell (1) according to one of the preceding claims, **characterized in that** the passivation layer (3) has at the semiconductor layer surface (20) a surface charge density of at most 10¹³ cm⁻², at most 10¹² cm⁻², or at most 10¹¹ cm⁻².

11. The solar cell (1) according to one of the preceding claims, **characterized in that** the chemically passivating passivation layer (31) has a layer thickness of at least 1 nm, 5 nm, 10 nm, 50 nm, or 100 nm.

12. A manufacturing method of a solar cell (1), **characterized in that** a chemically passivating passivation sublayer (31) and a field effect passivating passivation sublayer (33) are sequentially deposited on a semiconductor layer surface (20) of the solar cell (1) in such a manner that the chemically passivating passivation sub-layer (31) is arranged between the semiconductor layer (2) and the field effect passivating passivation sub-layer (33) on the semiconductor layer surface (20) to jointly form a passivation layer (3) which is formed as reflection layer for infrared light and which is a backside passivation arranged on a solar cell backside of the solar cell (1) not facing light, wherein a cover layer of silicon nitride is deposited on the passivation layer (3).

13. The manufacturing method according to claim 12, **characterized in that** before deposition of the field effect passivating passivation sublayer (33) the chemically passivating passivation sublayer (31) deposited is used in a diffusion process as a diffusion barrier, in an etching process as an etching barrier and / or in a texture process as a texture barrier.

## Revendications

1. Une cellule (1) solaire comportant une couche (2) semi-conductrice et une couche (3) de passivation disposée sur une surface de la couche (2) semi-conductrice et pour passiver la surface (20) de la couche semi-conductrice, dans laquelle la couche (3) de passivation est une passivation arrière disposée sur un dos de cellule solaire de la cellule (1) solaire opposé à la lumière, est en forme de couche réfléchissante pour la lumière infrarouge et comprend une sous-couche (31) de passivation passivant de manière chimique et une sous-couche (33) de passivation passivant à effet de champ qui sont disposées l'une au-dessus de l'autre sur la surface (20) de la couche semi-conductrice, dans laquelle la sous-couche (31) de passivation passivant de manière chimique est disposée entre la couche (2) semi-conductrice et la sous-couche (33) de passivation passivant à effet de champ sur la surface (20) de la couche semi-conductrice et dans laquelle une couche couvrante de nitrure de silicium est déposée sur la couche (3) de passivation.

2. La cellule (1) solaire selon la revendication 1, **caractérisée en ce qu'**une couche intermédiaire est disposée entre la sous-couche (31) de passivation passivant de manière chimique et la sous-couche (33) de passivation passivant à effet de champ.

3. La cellule (1) solaire selon l'une des revendications 1 à 2, **caractérisée en ce que** la sous-couche (33) de passivation passivant à effet de champ est une couche formée par dépôt de couches atomiques, par dépôt CVD, par dépôt PECVD, par dépôt PVD ou par procédé sol-gel.

4. La cellule (1) solaire selon l'une des revendications 1 à 3, **caractérisée en ce que** la sous-couche (33) de passivation passivant à effet de champ a une épaisseur comprise entre 0,1 et 10 nm, entre 2 et 5 nm ou entre 10 et 15 nm.

5. La cellule (1) solaire selon l'une des revendications précédentes, **caractérisée en ce que** le matériau passivant à effet de champ ou la sous-couche (33) de passivation passivant à effet de champ est formée sensiblement en matériau ayant une densité de charge surfacique d'au moins 10¹² cm⁻² , de préférence d'au moins 5x10¹² cm⁻², de préférence d'au moins 10¹³ cm⁻².

6. La cellule (1) solaire selon l'une des revendications précédentes, **caractérisée en ce que** la sous-couche (33) de passivation passivant à effet de champ comprend de l'oxyde d'aluminium, du fluorure d'aluminium, du nitrure de silicium, d'oxynitrure d'aluminium et / ou un autre composé d'oxyde d'aluminium et un ou plusieurs autre éléments.

7. La cellule (1) solaire selon l'une des revendications précédentes, **caractérisée en ce que** la sous-couche (31) de passivation passivant de manière chimique comprend un matériau semi-conducteur amorphe ou un oxyde semi-conducteur.

8. La cellule (1) solaire selon l'une des revendications précédentes, **caractérisée en ce que** la sous-couche (31) de passivation passivant de manière chimique est formée d'un composé de silicium avec l'oxygène, nitrogène et / ou carbone.

9. La cellule (1) solaire selon l'une des revendications précédentes, **caractérisée par** une passivation des deux côtés au moyen de la couche (3) de passivation.

10. La cellule (1) solaire selon l'une des revendications précédentes, **caractérisée en ce que** la couche (3) de passivation a à la surface (20) de couche semi-conductrice une densité de charge surfacique d'au maximum 10¹³ cm⁻², maximum 10¹² cm⁻² ou maximum 10¹¹ cm⁻².

11. La cellule (1) solaire selon l'une des revendications précédentes, **caractérisée en ce que** la sous-couche (31) de passivation passivant de manière chimique a une épaisseur d'au moins 1 nm, 5 nm, 10 nm, 50 nm ou 100 nm.

12. Un procédé de fabrication d'une cellule (1) solaire, **caractérisé en ce qu'**une sous-couche (31) de passivation passivant de manière chimique et une sous-couche (33) de passivation passivant à effet de champ sont déposées séquentiellement sur une surface (20) de couche semi-conductrice de la cellule (1) solaire de telle sorte que la sous-couche (31) de passivation passivant de manière chimique est disposée entre la couche semi-conductrice (2) et la couche (33) de passivation passivant à effet de champ sur la surface (20) de la couche semi-conductrice pour former conjointement une couche (3) de passivation en forme de couche réfléchissante pour la lumière infrarouge qui est une passivation arrière disposée sur un dos de cellule solaire de la cellule (1) solaire opposé à la lumière, dans lequel une couche couvrante de nitrure de silicium est déposée sur la couche (3) de passivation.

13. Le procédé de fabrication selon la revendication 12, **caractérisé en ce qu'**avant le dépôt de la sous-couche (33) de passivation passivant à effet de champ la sous-couche (31) de passivation passivant de manière chimique déposée est utilisée dans un processus de diffusion comme barrière de diffusion, dans un processus de gravure comme barrière de gravure et / ou dans un processus de texture comme barrière de texture.
